# EUROPEAN PATENT SPECIFICATION

(11) **EP 1 533 657 B1**
(45) Date of publication and mention of the grant of the patent: **09.03.2011**
(21) Application number: 03078683.4
(22) Date of filing: 21.11.2003
(51) Int. Cl.: G03F 7/00, B29C 33/60

(54) **Multilayer nano imprint lithography**
Nanoimprint Lithographie in Mehrschichtsystemem
Lithographie par nanoimpression sur systèmes à couches multiples

(43) Date of publication of application: 25.05.2005
(73) Proprietor: Obducat AB, 201 25 Malmö (SE)
(72) Inventor: Heidari, Babak, 244 65 Furulund (SE); Beck, Marc, 226 53 Lund (SE)
(74) Representative: Aurell, Henrik

(56) References cited:
- US-A1- 2003 017 424
- US-A1- 2003 127 580
- US-A1- 2003 159 608
- US-B1- 6 309 580
- SUN X ET AL: "MULTILAYER RESIST METHODS FOR NANOIMPRINT LITHOGRAPHY ON NONFLAT SURFACES" JOURNAL OF VACUUM SCIENCE AND TECHNOLOGY: PART B, AMERICAN INSTITUTE OF PHYSICS. NEW YORK, US, vol. 16, no. 6, November 1998 (1998-11), pages 3922-3925, XP001025600 ISSN: 0734-211X
- NATALI M ET AL: "Nanoimprint lithography of high-density cobalt dot patterns for fine tuning of dipole interactions" J. VAC. SCI. TECHNOL. B, MICROELECTRON. NANOMETER STRUCT. (USA), JOURNAL OF VACUUM SCIENCE & TECHNOLOGY B (MICROELECTRONICS AND NANOMETER STRUCTURES), NOV. 2001, AIP FOR AMERICAN VACUUM SOC, USA, vol. 19, no. 6, November 2001 (2001-11), pages 2779-2783, XP002274774 ISSN: 0734-211X
- BUREAU M ET AL: "PHOTORESIST DEPOSITION WITH NITROGEN TO SUPPRESS THE DEWETTING PROBLEM" IBM TECHNICAL DISCLOSURE BULLETIN, IBM CORP. NEW YORK, US, vol. 22, no. 5, 1 October 1979 (1979-10-01), pages 1884-1885, XP002055444 ISSN: 0018-8689

## Description

### TECHNICAL FIELD

The present invention relates generally to the field of nanoimprint lithography and more specifically to methods and means for generating a nano-scale pattern on a substrate.

### STATE OF THE ART

Quantum devices whose performance is influenced by the materials being structured in the nanometer-scale e.g. single-electron devices, are promising for the coming electronic generations. Developments of nanofabrication technologies are essential for production of such nano-devices. In practice extreme e-beam lithography as well as AFM-based methods (Atomic Force Microscope) for manipulation of nano-particles have made it possible to fabricate structures and patterns with dimensions down to some few nanometers. However, those techniques are working in a serial manner preventing these nano lithographies to be applied for mass fabrication of devices. Nanoimprint lithography , (NIL) has the inherent potential to be a promising candidate for fabrication of such nanodevices in parallel. Here, a stamp patterned with a serial lithography technique, most often e-beam lithography, can be utilised for replications in a stamp-print approach, quite similar to the compact-disc (CD) manufacturing process. The CD production technique was introduced 1975, having shown it's excellent mass production capability. CD production has a total (worst case) yield better then 67% in the full area of each 6" compact disc being produced.

Nanoimprint lithography (NIL) is a known technique for producing a nano scale pattern on a substrate. The substrate can e.g. be a semiconductor material, such as silicon, indium phosphide or gallium arsenide, and used e.g. for the production of semiconductor components. The substrate can also be of other materials such as ceramic materials, metals or polymers with a relatively high glass transition temperature, in case of other applications such as e.g. biosensors.

The trend in microelectronics is towards ever smaller dimensions. In principle, development has been such that the dimensions are reduced to their half size about every third year. For instance, commercial components are manufactured today with structures of about 130 nm in size, but there is a need to go even further down in dimensions.

The basic principle of NIL is mechanical deformation of a thin film layer, which is coated onto a flat plate of e.g. silicon. The NIL process can be compared with the production process for CD:s and can be described in three stages:
1. Production of a mould (i.e. a mould template): A mould can be produced from various materials, e.g. metal, semiconductor, ceramic or from certain plastics. To create a three-dimensional structure on one surface of the mould, various lithographic methods can be used, depending on the requirements for the size of the structures and their resolution. E-beam and X-ray lithography are normally used for structure dimensions that are less than 300 nm. Direct laser exposure and UV lithography are used for larger structures.
2. Imprint: A thin film layer of a polymer, e.g. polyamide, is applied to a flat substrate of silicon. The layer is heated to a certain temperature, the so-called imprint temperature. The mould and substrate are pressed together so that the inverse structure of the mould is transferred to the polymer layer on the substrate. During the imprint step, the resist is heated to a temperature above its glass transition temperature. At that temperature, the resist, which is thermoplastic, becomes a viscous liquid and can flow and, therefore, can be readily deformed into the shape of the mold. The resist's viscosity decreases as the temperature increases.
3. Structure transfer: In the areas pressed together in the polymer layer, a thin layer of polymer remains. The last stage is removal of this thin remaining layer on the substrate. This can be carried out in a so-called "RIB" or 0₂-plasma unit or in an anisotropic etching process, such as reactive ion etching, RIE. The thinner this remaining layer is, the finer the structures that can be created using the nanoimprint.

A problem with conventional NIL procedures is that the mould can adhere to the thin film layer during pressing which makes the transferred inverse pattern in the thin film layer less accurate. Therefore, the mould is normally provided with a thin anti-adhesive layer in order to avoid such adhesion.

The article "Step and Flash Imprint Lithography:A New Approach to High-Resolution Patterning", Proc. SPIE Vol. 3676, 379-389 (1999), by Willson et al, describes a polymer imprint resist layer with integrated anti-adhesive material in the polymer.

Another imprint method uses imprint in combination with UV exposure to cure a polymer. This alternative approach to lithography is based on a bilayer imprint scheme. In this process, a standard quartz mask with a patterned chromium surface is reactive ion etched, producing high-resolution relief images in the surface. The remaining chromium is removed and the template is surface treated with a fluorinated self-assembled monolayer. A low-viscosity, photopolymerizable formulation is introduced into the gap between the two surfaces. The template is then brought into contact with the substrate. This solution, called the etch barrier, is photopolymerized by exposure through the backside of the quartz template. The template is separated from the substrate, leaving a UV-cured replica of the relief structure on the substrate. Features smaller than 40 nm in size have been reliably produced using this imprinting process. A problem/drawback with this technique is that it is not suitable for large area imprint without stepping and stamping/flashing, where the polymer has to be dispensed prior to each imprint step.

There are several challenging problems associated with imprint lithography methods. One critical area is to perform the next level of processing while maintaining the same resolution demonstrated in the polymer layer. The formation of patterned metal layers is one application. Finely patterned metal layers are used as interconnects in integrated circuits. They can also be used as catalysts for subsequent layer growth. If the subsequent metal layers cannot readily be etched, e.g., due to crystal direction dependent etching rates, an additive approach such as lift-off is desirable. However, single polymer layers are problematic when transferring the pattern via metal lift-off. The nonvertical sidewalls resulting from the imprinting process result in tearing and detachment of the metal film during lift-off. Nonvertical sidewalls occur in imprint lithography if the imprinting element does not have vertical sidewalls. Even if the imprinter does have vertical sidewalls, nonvertical sidewalls are formed in the imprinted film due to a descumming step necessary to remove residual polymer from the bottom of the imprinted feature. Therefore, a technique is required that minimizes the problems associated with metal lift-off using single layer resists.

There are other problems with those imprint techniques, which are addressed by the present invention such as changes in surface adhesion properties if substrate and organic materials are varied. This causes the process to be limited to polymer material in combination with specific substrate materials such as silicon, nickel, quartz, glass, silicon nitride etc. Using a release agent on the mold is not safe enough to be sure that the process can be used in industrial production.

The document 'MULTILAYER RESIST METHODS FOR NANOIMPRINT LITHOGRAPHY ON NONFLAT SURFACES', by Sun X et al, published in "JUORNAL OF VACUUM SCIENCE AND TECHNOLOGY: PART B, AMERICAN INSTITUTE OF PHYSICS. NEW YORK, US, vol. 16, no 6, November 1998, discuss a flexible Nanoimprint lithography method wherein many materials can be used to achieve optimum results when imprinting on non flat surfaces. The document 'NANOIMPRINT LITHOGRAPHY OF HIGH-DENSITY COBALT DOT PATTERNS FOR FINE TUNING OF DIPOLE INTERACTIONS', by M. NATALI et al, published in J. Vac. Sci. Technol. B 19(6), Nov/Dec 2001, discuss a Nanoimprint lithography method using hybrane as the top layer resist which gives better dimensional control of the replicated patterns compared to PMMA (Polymethylmethacrylate).

It thus exists a need to find nano imprint litography methods and means providing the possibility to transfer even finer nano-scale structures from a mould to a substrate in an economical way and eliminating/alleviating the problem concerning adhesion of the mould to the substrate during imprinting.

### SUMMARY OF THE INVENTION

The object of the present invention is to eliminate/alleviate above drawbacks/problems.

One object of the present invention is thus to find nano imprint litography methods and means providing the possibility to transfer even finer nano-scale structures from a mould to a substrate.

Another object of the present invention is to find nano imprint litography methods and means, which alleviate the problem concerning adhesion of the mould to the substrate during imprinting.

Still another object of the present invention is to find nano imprint litography methods and means, which improve the accuracy of the imprint pattern on the substrate.

A further object of the present invention is to provide nano imprint litography methods and means which improves imprinting quality by reducing the sticking of polymer on to the mould surface and the release of polymer from the substrate.

Still a further object of the present invention is to provide nano imprint litography methods and means which provide the possibility of economical mass production of nano-structures of higher accuracy.

According to one aspect of the present invention, the invention accomplishes above objects by a method for forming a structured pattern on a substrate wherein said substrate is coated with a plurality of coating layers before pressing, where each coating layer has a specific function and

the uppermost coating layer on top of the substrate has a pure anti-adhesive function.

According still another aspect of the invention, a substrate is provided for forming a nano scale pattern on said substrate wherein said substrate is coated with a plurality of coating layers each having a specific function and the substrate has an uppermost coating layer having a pure anti-adhesive function.

Although the present invention has been summarised above, the present invention is defined by the independent claims 1 and 8. Further embodiments of the invention are defined by the dependent claims 2-7, 9-11.

### BRIEF DESCRIPTION OF THE DRAWINGS

Figure 1 illustrates a substrate and mould for forming a nano scale pattern according to the invention.
Figure 2 illustrates a flow chart for a method for providing a nano scale pattern on a substrate, which can be used to carry out the invention.

### DETAILED DESCRIPTION OF PREFERRED EMBODIMENTS

The present invention is based on the identification of problems/drawbacks with integrating an anti-adhesive material in the polymer imprint resist layer on the substrate during nano-imprint lithography, as described e.g. in the above mentioned article "Step and Flash Imprint Lithography:A New Approach to High-Resolution Patterning", Proc. SPIE Vol. 3676, 379-389 (1999), by Willson et al, describes a polymer imprint resist layer with integrated anti-adhesive material in the polymer. This approach gives far from optimal antisticking performance, leading to sticking of polymer to the mould and as a consequence hinders an economical mass production of even fmer nano-scale patterns on substrates.

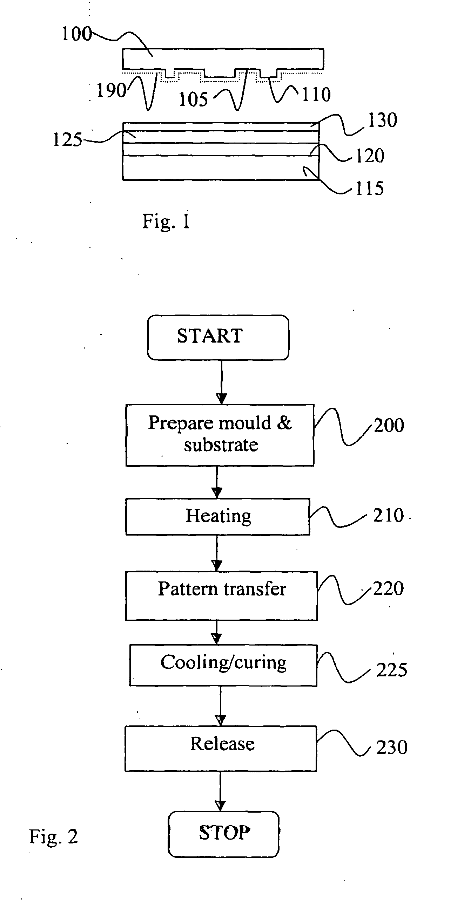

The present invention is illustrated in figure 1. A mould 100 has recesses 105 and protrusions 110 forming a nano structure pattern. The protrusions have the height of about 150 nm. The mould 100 can be made of any suitable material such as e.g. glass, silicon or metal such as nickel, as known to a person skilled in the art. According to a preferred embodiment, the mould is coated with a thin anti-adhesive layer 190 (also referred to as antisticking layer) in form of a Teflon _{TM} - like monolayer. The thickness of layer 190 is about 10 nm or less and can e.g. be obtained by chemical vapour deposition onto the stamp as known to a person skilled in the art. A substrate 115 made of any suitable material such as e.g. silicon (or silicon glass) as known to a person skilled in the art, is provided. The substrate 115 is coated with a thin adhesive layer 120 (also referred to as sticking layer) consisting e.g. of 3-methacryl-oxypropyl-dimethyl-chlorosilane or hexamethyldisilane, HMDS. The layer 120 is preferably about 10 nm or less and can be obtained by e.g. spin coating. A forming layer (also referred to as an imprint resist layer) 125 is then provided on top of layer 120 and may consist of e.g. PMMA (PolyMethyl-Methacrylic Acid) and has a preferred thickness of about 150 nm. The imprint PMMA layer 125 can be provided by using a suitable known technique such as spin coating. According to the invention, an anti-adhesive layer 130 is provided on top of imprint resist layer 125. The anti-adhesive layer 130 comprises tridecafluro- (1H,1H,2H,2H) tetrahydrooctylamine or similar partially or completely fluorinated compounds. The anti-adhesive layer 130 has preferably a thickness of 10 nm or less and can e.g. be spin coated on the imprint PMMA polymer layer 125, as a person skilled in the art realises.

Referring to figure 2 a flow chart for the nano-imprint method according to the present invention is illustrated. In step 200, a mould 100 and a substrate 115 are prepared in accordance with the description above referring to figure 1. In step 210, the substrate 115 with the three layers 120, 125, 130 and the mould 100 are then heated above the glass transition temperature, causing the softening of layer 125. In step 220, the pattern transfer is carried out by pressing the mould into the substrate coatings 120, 125, 130 using a gas pressure of about 5 to 100 bar, preferably about 30-60 bar, for <300 sec., in accordance with a so called soft imprint method. The soft imprint method makes use of a pressure controlled chamber with a flexible membrane forming a counterstay for the substrate/mould for pressing the substrate and mould together with an even distribution of force between them. The soft imprint method is disclosed in the published international patent application WO01/42858 A1. Thereafter the forming layer 125 is solidified by cooling and curing in a known manner in step 225. In step 230, the mould 100 is released from the substrate 115. In this way a structured nano-scale pattern is provided on the substrate by transferring an inverse pattern on the mould.

The present invention overcomes the problems and drawbacks associated with known techniques by providing the substrate with an uppermost anti-adhesive layer on top of e.g. the imprint resist layer. This facilitates an even distribution of the anti-adhesive layer and also makes the evenness of the anti-adhesive layer less critical for the accuracy and fineness of the final imprint result. The invention provides a thin monolayer, such as a Teflon _{TM} - like monolayer, as an anti-adhesive layer, on the mould. The thickness of the Teflon _{TM} - like monolayer is about 10 nm or less according to the invention, however the thickness might vary depending on the chemistry applied.

By using the imprint technique according to the invention, the imprint result shows a higher quality with practically no sticking of polymer to the mould surface and no release of polymer from the substrate. Furthermore, the imprint result indicates that the above problem regarding nonvertical sidewalls is alleviated. Thus, a nano pattern imprint method providing a higher accuracy, which also permits an economical mass production of even finer structures on a substrate has been disclosed.

The invention has been described by means of illustrative examples. The figures are not to scale but illustrate merely the working principle of the invention. Many modifications are possible for a person skilled in the art, e.g. regarding additional functional layers, e.g. to introduce a so called lift-off layer etc, between the substrate 115 and the anti-adhesive layer 130 without departing from the scope of the invention as defined by the following claims.

## Claims

1. A nanoimprint lithography method for providing a structured nano scale pattern on a substrate (115) by transferring an inverse pattern from a mould (100) to said substrate (115) by pressing said mould and substrate together, said substrate being coated with a plurality of coating layers, comprising an imprint resist layer (125), said method **characterised in that** it comprises the step of:
- providing an uppermost coating layer (130) on top of the substrate having a pure anti-adhesive function before pressing.

2. The method of claim 1 further comprising the step of:
- providing a sticking layer (120) disposed under said imprint resist layer (125), before pressing.

3. The method according to claim 1 further comprising the step of:
- forming said anti-adhesive layer (130) so it comprises partially fluorinated compounds.

4. The method according to claim 1 further comprising the step of:
- forming said anti-adhesive layer (130) so it comprises completely fluorinated compounds.

5. The method according to claim 1 further comprising the step of:
- forming said anti-adhesive layer (130) so it comprises tridecafluro-(1H,1H,2H,2H) tetrahydrooctylamine.

6. The method according to claim 1 further comprising the step of:
- providing an anti-adhesive layer (190) on said mould before pressing.

7. The method according to claim 1 further comprising the step of:
- providing a substantially even distribution of force between said substrate and mould by using a pressure controlled chamber having a flexible membrane on which said substrate or mould is disposed during the transfer of said pattern to said substrate (115).

8. A substrate (115) devised for forming a nano scale pattern on said substrate by means of nanoimprint lithography, said substrate (115) being coated with a plurality of coating layers, comprising an imprint resist layer (125), **characterised in that** the uppermost coating layer (130) on top of the substrate is formed by a compound giving it a pure anti-adhesive function.

9. The substrate according to claim 8, wherein said anti-adhesive layer (130) comprises a partially fluorinated compound.

10. The substrate according to claim 8, wherein said anti-adhesive layer (130) comprises a completely fluorinated compound.

11. The substrate according to claim 9, wherein said anti-adhesive layer (130) comprises tridecafluro- (1H,1H,2H,2H) tetrahydrooctylamine.

## Patentansprüche

1. Ein Nano-Eindruck-Lithographieverfahren zur Bereitstellung eines strukturierten Musters im Nanomaßstab auf einem Substrat (115) durch Überführen eines inversen Musters von einer Form (100) auf das Substrat (115) durch Zusammenpressen der Form und des Substrates, wobei das Substrat mit einer Vielzahl von Beschichtungsschichten beschichtet ist, umfassend eine Eindruckresistschicht (125), und wobei das Verfahren **dadurch gekennzeichnet ist, dass** es den Schritt umfasst:
- Bereitstellen einer äußersten Beschichtungsschicht (130) oben auf dem Substrat, welche vor dem Drucken eine rein antiadhäsive Funktion aufweist.

2. Das Verfahren gemäß Anspruch 1, umfassend weiterhin den Schritt:
- vor dem Drucken Bereitstellen einer Klebeschicht (120) unter der Eindruckresistschicht (125).

3. Das Verfahren gemäß Anspruch 1, umfassend weiterhin den Schritt:
- Bilden der antiadhäsiven Schicht (130) in der Weise, dass sie teilweise fluorierte Verbindungen umfasst.

4. Das Verfahren gemäß Anspruch 1, umfassend weiterhin den Schritt:
- Bilden der antiadhäsiven Schicht (130) in der Weise, dass sie vollständig fluorierte Verbindungen umfasst.

5. Das Verfahren gemäß Anspruch 1, umfassend weiterhin den Schritt:
- Bilden der antiadhäsiven Schicht (130) in der Weise, dass sie Tridecafluor-(1H,1H,2H,2H)tetrahydrooctylamin umfasst.

6. Das Verfahren gemäß Anspruch 1, umfassend weiterhin den Schritt:
- Bereitstellen einer antiadhäsiven Schicht (190) auf der Form vor dem Drucken.

7. Das Verfahren gemäß Anspruch 1, umfassend weiterhin den Schritt:
- Bereitstellen einer im Wesentlichen gleichmäßigen Verteilung der Kraft zwischen dem Substrat und der Form durch die Benutzung einer druckgesteuerten Kammer, welche eine flexible Membran aufweist, auf welcher das Substrat oder die Form während der Übertragung des Musters auf das Substrat (115) platziert ist.

8. Ein Substrat (115), hergerichtet um ein Muster im Nanomaßstab auf dem Substrat durch Nano-Eindruck-Lithographie zu bilden, wobei das Substrat (115) mit einer Vielzahl von Beschichtungsschichten beschichtet ist, umfassend eine Eindruckresistschicht (125), **dadurch gekennzeichnet, dass** die äußerste Beschichtungsschicht (130) oben auf dem Substrat durch eine Verbindung gebildet ist, welche ihr eine rein antiadhäsive Funktion verleiht.

9. Das Substrat gemäß Anspruch 8, wobei die antiadhäsive Schicht (130) eine teilweise fluorierte Verbindung umfasst.

10. Das Substrat gemäß Anspruch 8, wobei die antiadhäsive Schicht (130) eine vollständig fluorierte Verbindung umfasst.

11. Das Substrat gemäß Anspruch 9, wobei die antiadhäsive Schicht (130) Tridecafluor-(1H, 1H,2H,2H)tetrahydrooctylamin umfasst.

## Revendications

1. Procédé de lithographie par nano-impression pour former un motif à l'échelle nanométrique structuré sur un substrat (115) par transfert d'un motif inverse à partir d'un moule (100) sur ledit substrat (115) par pressage ensemble desdits moule et substrat, ledit substrat étant revêtu d'une pluralité de couches de revêtement, comprenant une couche de réserve d'impression (125), ledit procédé étant **caractérisé en ce qu'**il comprend l'étape consistant à :
- disposer une couche de revêtement supérieure (130) sur le dessus du substrat ayant une fonction antiadhésive pure avant pressage.

2. Procédé selon la revendication 1, comprenant en outre l'étape consistant à :
- disposer une couche adhésive (120) sous ladite couche de réserve d'impression (125), avant pressage.

3. Procédé selon la revendication 1, comprenant en outre l'étape consistant à :
- former ladite couche antiadhésive (130) de façon qu'elle comprenne des composés partiellement fluorés.

4. Procédé selon la revendication 1, comprenant en outre l'étape consistant à :
- former ladite couche antiadhésive (130) de façon qu'elle comprenne des composés complètement fluorés.

5. Procédé selon la revendication 1, comprenant en outre l'étape consistant à :
- former ladite couche antiadhésive (130) de façon qu'elle comprenne de la tridécafluoro(1H,11H,2H,2H)-tétrahydrooctylamine.

6. Procédé selon la revendication 1, comprenant en outre l'étape consistant à :
- disposer une couche antiadhésive (190) sur ledit moule avant pressage.

7. Procédé selon la revendication 1, comprenant en outre l'étape consistant à :
- obtenir une distribution de forces pratiquement uniforme entre lesdits substrat et moule par utilisation d'une chambre régulée en pression ayant une membrane flexible sur laquelle ledit substrat ou moule est disposé durant ledit transfert dudit motif sur ledit substrat (115).

8. Substrat (115) prévu pour que soit formé un motif à l'échelle nanométrique sur ledit substrat au moyen d'une lithographie par nano-impression, ledit substrat (115) étant revêtu d'une pluralité de couches de revêtement, comprenant une couche de réserve d'impression (125), étant **caractérisé en ce que** la couche de revêtement supérieure (130) sur le dessus du substrat est formée d'un composé lui conférant une fonction antiadhésive pure.

9. Substrat selon la revendication 8, dans lequel ladite couche antiadhésive (130) comprend un composé partiellement fluoré.

10. Substrat selon la revendication 8, dans lequel ladite couche antiadhésive (130) comprend un composé complètement fluoré.

11. Substrat selon la revendication 8, dans lequel ladite couche antiadhésive (130) comprend de la tridécafluoro(1H,1H,2H,2H)tétrahydrooctylamine.
